Europäisches Patentamt

European Patent Office

Office européen des brevets

(11) Publication number: **0 141 868**
**A1**

## EUROPEAN PATENT APPLICATION

(21) Application number: **83111304.8**

(22) Date of filing: **11.11.83**

(51) Int. Cl.⁴: **G 03 F 7/16,** G 03 F 7/20

(43) Date of publication of application: **22.05.85**
**Bulletin 85/21**

(84) Designated Contracting States: **BE DE FR IT NL SE**

(71) Applicant: **Sullivan, Donald Fort, 15 Devon Blvd., Devon Pennsylvania (US)**

(72) Inventor: **Sullivan, Donald Fort, 15 Devon Blvd., Devon Pennsylvania (US)**

(74) Representative: **Haft, Berngruber, Czybulka, Hans-Sachs-Strasse 5, D-8000 München 5 (DE)**

(54) **High resolution phototransparency image forming with photopolymers.**

(57) A photopolymer layer is coated onto a printed wiring board (1) and a phototool film (4) is positioned over the board in register and off-contact. A resilient blade (10) is pressed against the phototool (4) at one end of the board and drawn across the surface, thus forcing the phototool film into intimate contact with the photopolymer and purging all air therebetween. Mounted on the resilient blade aft of the leading edge is a shuttered tubular lamp (14) which hardens the photopolymer where the phototool film is clear, so that in a single pass the photographic film is sequentially mated and the photopolymer expo to produce line widths unmatched by competing dry film systems and at speeds of 0.15 m per second.

Heat problems are resolved by faster exposure time and dissipation of heat with liquid coolants (18). In one embodiment the photopolymer is cured underwater to keep out air and increase curing speed while serving as a coolant.

-1-

## HIGH RESOLUTION PHOTOTRANSPARENCY
## IMAGE FORMING WITH PHOTOPOLYMERS

### Technical Field

This invention relates to photoimage processing and apparatus for producing images of high resolution on substrates, such as printed wiring boards, from photopolymers, and more particularly it relates to techniques for producing improved low energy high resolution photopolymer images with laminations of photopolymer and photo image bearing tools.

## Background Art

Graphic images are produced on substrates, using photopolymers such as paste-consistency untraviolet light (UV) curable photopolymers. These photopolymers, known as negative acting, are characterized by their composition of 100 percent reactive polymers, which are transformed from a paste-consistency soluble wet film to an insoluble dry coating by exposure to a strong UV light source for several seconds. The photopolymers as used in the disclosed process are further characterized as being imaging quality, or capable of being selectively hardened by light passing through a photographic tool master bearing a photo image pattern, thereby producing an insoluble film pattern securely affixed to a substrate, at locations where the photographic master allows the UV light to impinge on the photopolymer. These photopolymers are available commercially as plating resists and as etch resists for use in printed wiring board (PWB) manufacture, and graphics imaging, for example. They are applied conventionally by screen printing through an image bearing screen stencil to deposit images on the substrates as wet photopolymer, which are then cured and transformed into permanent images by being subjected to a strong UV light source.

Positive acting dry film photopolymers are insoluble until converted by radiation through the transparency part of a photo tool image pattern into soluble state.

The screen printed photopolymer images of the prior art are characterized by large energy expenditure, heated substrates, indistinct boundaries, loss of fidelity, smeared images and requirement for collination of radiation.

The images which can be achieved using the disclosed process and apparatus and the same photopolymers in resolving these problems are characterized even with negative photopolymers by lines having sharp, distinct boundaries, exceptional fidelity with film thicknesses up to .002 inches (.05mm) and no smearing. For example, screen printed PWB resist patterns are practically limited to conductor widths and spacing of .010 inches (.254 mm) minimum, while the same photopolymers can be imaged as disclosed herein to produce line widths and spacings of .003 inches (.076 mm), with a film thickness of .00025 inches (.006 mm). Screen printed half-tone images are limited to a practical upper range of 105 lines, with dot sizes of 20 to 80 percent. The same photopolymer imaged as described herein can produce half-tone graphics of 150 lines, with dot sizes of 5 to 95 percent.

Exemplary prior art for preparation of photopolymer printing plates used with phototransparency imaging includes U.S. Patent 4,070,110 - J. W. Ott, Jan. 24, 1978 for producing photopolymer relief printing plates in a semi-automated process. Thus a sandwich array is prepared by laminating a cover film and backing sheet with intermediate photopolymer applied in liquid form and hardened by partial exposure to light. The sandwich is after being completely formed, flattened under pressure, while exposing through the phototransparencies. A complex machine array for a similar laminating and followthrough developing process is shown also in U.S. Patent 4,087,182 - H. Aiba et al., May 2, 1978. These are contact printing processes as compared with a photo imaging process such as described in U.S. Patent 4,052,603 - K. Karlson, Oct. 4, 1977.

Also, U.S. Patent 3,837,887 - K. Akamatsu et al., Sept. 24, 1974 provides a sandwich type printing plate for liquid photopolymers. All of these involve complex and expensive machinery and could not result in simple single pass lamination and exposure scanning as can the present invention.

All of the prior art also uses a relatively thick release film layer in contact with both liquid photopolymer and dry photopolymer surface to be irradiated which thus is interposed between the phototransparency (or other) image to be reproduced and the photopolymer surface to substantially reduce resolution.

Another problem not presented or resolved in the prior art is that of preventing contamination and wear of a photopolymer surface with a reusable phototransparency image bearing surface that contacts the photopolymer surface. For example, relatively thick polypropylene release films are interposed in the prior art. A phototool which contacts the photopolymer layer has a very short reusable life because of scratching, wear and accumulation of hardened photopolymer, etc.

My U.S. Patent 4,260,675 of April 7, 1981 employs liquid photopolymers for preparing printed circuit board solder masks wherein a relief pattern of posts physically pushes aside liquid photopolymer before exposure by radiation through interposed air to harden the photopolymer and leave uncured photopolymer in those places where solar is to adhere to the circuit board conductors.

The glass phototool assembly experiences a temperature rise from repetitious use, for the solder mask photopolymer thickness is of the order of .005 inches* and to cure down to the base laminate an energy density of 6 joules per square centimeter is required. To some degree, the

* (= 0,127 mm) photoresist is air inhibited, even though a vacuum of 20 inches of mercury is used. The temperature build-up is typically up to 200 degrees F. (= 93,3°C)

Another application for photopatterning liquid photopolymers is practiced by the W.R. GRACE COMPANY in their "ACCUTRACE" system. A plating resist is photo-patterned onto PWB by off-contact exposure using a collimated light source. An off-contact separation distance of the order of .007 inches circumvents the problems associated with phototool contact with the liquid resist, but at a sacrifice in resolution, since light undercutting is experienced even with a collimated light source.

Also this increases the curing time by permitting air and oxygen to contact the photopolymer surface and making the energy consumption high and the temperature rise great.

Known technique for circumventing the oxygen-inhibition effects on photocurable polymers includes the use of a nitrogen or neutral gas blanket over the photopolymer surface. The LINDE division of UNION CARBIDE manufactures a UV reactor in which nitrogen displaces air in the exposure volume, resulting in the reported ability to reduce lamp power significantly while maintaining curing speed and cured film thickness. The use of nitrogen, however, is expensive, and losses must be constantly replaced.

Another known method for excluding air is to overlaminate the photopolymer-coated substrate with a clear plastic film. This process is not readily adaptable to the photoformation of solder masks on printed wiring boards for several reasons. First, the rough surface topography presented by raised printed wiring conductors makes it difficult to overlaminate a thin plastic sheet without air entrapment and without the liquid photopolymer being extruded from the top surfaces of narrow conductors

-6-

and producing areas of uneven photopolymer thickness

Furthermore, the use of liquid consistency photopolymers has not been feasible in many applications because of thinning over circuit traces or seeping into eyelets or causing fisheyes in contact with non-wetting surfaces which can be stripped from the polymer or because of sticking in part to build-up ridges.

The present invention has as a general object, the simplicity and improvement of prior art equipment and processes for producing printed elements of high resolution with photopolymers.

Another object of the invention is to resolve a number of problems in the art including those now briefly discussed.

In the prior state of the photopolymer printing arts considerable time and expense is involved in heating and cooling photopolymers between various steps to soften, to adhere, to develop, etc. These problems are resolved by the present invention by reducing the exposure time to reduce the heat and energy requirements by exclusion of air from the photopolymer surfaces during exposure, and by simplifying the process to require fewer steps, fewer layers of film, etc. Expensive collimated radiation sources have been required in exposing photopolymers.

Selective adherence and non-adherence of photopolymer films at different stages of the photo process has been a difficult problem. For example, a dry film need be heated to adhere properly to a substrate without air bubbles, etc. This invention can resolve this adherence problem by spreading paste-consistency liquid photopolymers over the substrate surfaces. Also, when dry film hardening agents are involved they are difficult to remove in the development stage. By using a photo cycle of hardening liquid polymers, the unexposed liquid is easy to wash out of eyelet holes, etc. and simplifies the development step. Also solvents are less apt to undercut exposed polymer to reduce definition. Thinner films of liquid photopolymer save polymer costs and result in better resolution.

Another objective is the use of apparatus and photopolymers which greatly reduce the total cost of image formation, by use of less expensive equipment, less expensive photopolymer and by increasing the productivity of personnel.

This disclosure also teaches improved methods for processing the wet photopolymer coatings to achieve the precision images detailed herein.

One objective is to mate the photopolymer-coated phototool with the substrate so as to exclude air from the photopolymer.

Another objective is to speed up the normal exposure cycle of dry film photoresists consisting of vacuum drawdown then exposure.

Another objective is to provide a way to coat a non-wetting surface, in such a way that the applied photopolymer does not develop fish-eyes or voids.

Therefore the present invention has as a general object, the simplicity and improvement of prior art equipment and processes for producing printed elements of high resolution with liquid photopolymers, and explicitly to provide special phototransparency imaging tools and techniques particularly adapted to produce high resolution images.

## Disclosure of the Invention

Negative acting photopolymers are applied as a layer in the wet state and converted to a hardened polymerized image state by exposure to light through specially formulated phototransparencies directly in contact with the photopolymer surface. Thus a significant improvement is attained an image resolution over known competing imaging processes.

Exclusion of air from the liquid photopolymer during the photo exposure step by sandwiching the polymer between two layers one of which carries a phototransparency image, exposure time is decreased, energy is decreased, speed of production is increased, temperature is decreased and resolution is improved.

Apparatus provided scans and mates one area of the PWB, photopolymer and phototool into a sandwich array with a gas (bubble) free photopolymer surface while a previously-mated area is being radiated and exposed, so that on a single scan the mating and exposure is accomplished.

The process consists of the steps of preparing a phototool (or photomask) which describes the images to be reproduced, with clear areas of a non-stick material on the substrate-facing surface; the coating of the phototool with a thin layer of photopolymer; the partial polymerization of the photopolymer to prevent de-wetting on non-stick phototool areas; the placement of the phototool above and off-contact to the substrate being imaged; the mating of the phototool with the substrate so as to exclude all air by use of a resilient blade drawn across the topside of the phototool; the selective exposure of the photopolymer through the phototool by a tubular mercury vapor lamp which traverses the phototool just behind the resilient blade. Thus, in one pass, images are produced at a scan rate of one foot (.3 M) per 2 seconds. Following exposure, the substrate is peeled away from the phototool and subjected to a solvent spray removing unhardened photopolymer, leaving the desired image securely affixed to the substrate.

The described process and disclosed apparatus enables images of exceptional resolution to be generated, using many available photopolymers, generally described as UV-curing photopolymers. These photopolymers are currently being applied by screen printing and cured by UV radiation, for imaging printed wiring boards, for printing meter faces, name plates and screen-printed four color graphics. When these photopolymers are processed in accordance with this disclosure the images generated will faithfully reproduce phototool details, including lines having width and separations of three-thousandths of an inch (.076 mm). Further, images composed of half-tone dot patterns of 150 lines, from 5% to 95% can be faithfully reproduced.

By contacting the phototransparency image directly with the liquid photopolymer surface, the described processes and apparatus are capable of providing increased resolution images with a film thickness of between 0.25 thousandth of an inch (.006 mm) and over 2 thousandths of an inch (.05 mm). However, when certain types of transparency images are to be reused, they may lose resolution by scratching or by accumulating noise in the form of unremoved or partly cured photopolymers. Thus, the phototools comprising image reproducing phototransparencies are specially processed in this invention to provide improved resolution, longer life and synergetic relationships with liquid photopolymer layers.

In particular this invention provides images on photopolymer release surface contact films such as polypropylene, so that repeated stripping and reuse of image bearing phototools from a liquid polymer surface after exposure and hardening may occur without decreasing resolution capabilities due to scratching, damage to the image or accumulation of hardened photopolymer. For scratchproofing the phototools with image bearing surfaces, they are dyed into a polypropylene release film as a yellow dye which reduces heating compared with conventional photo image patterns. Thin aluminum photo pattern images also reduce heat generation in the phototool.

For dissipating heat a liquid is put into thermal contact with the curing surface and phototool as a cooling agent. In one embodiment the liquid acts also as a layer to exclude air and air bubbles from the surface of the photopolymer layer.

Thus, photoresist coating is applied to a PWB at a high rate of speed and with a high degree of precision on a production basis by immersing the coated PWB and the phototool in a liquid medium that does not affect photopolymer solubility perferably an aqueous solution, and exposing the photoresist while in the liquid medium.

A conventional glass plate phototransparency is prepared having opaque areas corresponding to PWB locations which are not to receive photocured resist.

A UV-curing unit simply comprises a shuttle conveyor conveying a tray carrying water under which a photopolymer coated substance such as a PWB is carried past the UV lamps. The PWB is coated uniformly with a photopolymer of known composition. Coating is accomplished by screen printing using a blank screen, or one without a stencil, so as to place photopolymer on all PWB surfaces, including land areas. The coated PWB is placed in the tray containing water, and all air is immediately displaced from the photopolymer surface. No significant chemical reaction takes place between the water and liquid photopolymer.

Next, the glass plate phototransparency is placed atop the coated board in register and in contact and conveyed past the tubular mercury-vapor lamps at a speed of the order of 15 feet per minute, hardening light-struck areas.  The assembly is removed, the phototool separated from the PWB, and the PWB is then subjected to a solvent spray bath to washout unexposed photopolymer.

The disclosed process is also useful in curing photopolymer on fragile substrates which are coated and then cured by UV light exposure, especially termperature-sensitive substrates like polyester film.

The disclosed process is amenable to photoimaging plating and etch resists and solder masks on printed wiring boards.

A preferred embodiment laminates two thin photopolymer layers on the irregular surface of a printed wiring board having thereon circuit traces and through holes.  Thus a first liquid negative acting polymer layer is disposed on the surface of the board and a second liquid photopolymer layer is disposed on a screen above the first layer and partially cured before lamination thereover.  Particular advantages may be achieved in some cases if the second layer is a positive acting dry film photopolymer.

An improved process for tenting over through holes on a printed wiring board with a liquid photopolymer layer is provided by disposing the liquid layer on a transfer screen before laminating onto the board to overlay said holes.  The liquid photopolymer may be partially polymerized such as by irradiation in air before lamination.

* (= 4,5 m)

Brief Description of the Drawings

Further background, objects, advantages and features of the invention will be set forth throughout the following specification with reference to the accompanying drawings wherein:

Figure 1 is a diagrammatic side view sketch, partly sectioned to illustrate the mating of a photoimage with a coated substrate by use of a resilient blade as provided by this invention;

Figure 2 is a further similar sketch illustrating the mating during an exposure step wherein a coolant dispenser and tubular lamp are co-mounted to protect the photoimage from excess heat and expose the photopolymer all on one scan;

Figure 3 is a perspective sketch of a fixture for mounting the photoimage and the substrate in register prior to being mated together with schematic control features;

Figure 4 is a perspective fragmental view of a simple unit for laminating and exposing a photopolymer containing sandwich array in accordance with the invention;

Figure 5 is a diagrammatic side view sketch of an image bearing phototool embodiment of the invention;

Figure 6 is a diagrammatic side view sketch of a further image bearing high resolution phototool embodiment of the invention, with a photoimage bearing surface in easily releasable contact with the liquid photopolymer surface;

Figure 7 is a fragmental view in cross section of an underwater exposure embodiment of the invention, and

Figure 8 is an elevation view, partly in section showing a preferred embodiment for a printed wiring board that laminates two layers of photopolymer thereover.

-13-

## Description of Preferred Embodiments

Computer grade PWB are typically manufactured in panel form with conductor lines and spaces of the order of 0.010 inches wide (.025 cm) having sharply defined edges, free of nicks and bulges. Additionally, the imaging resist forming the conductors must maintain a constant thickness, consistent with the plating or etching chemicals, temperature and immersion time. Too thin a resist results in breakdowns and the plating of metal at unwanted locations.

The UV curable photopolymers used in PWB manufacture have been developed to be applied by screen printing over the copper surface and cured by conveying under 200 watt-per inch mercury vapor lamps at a speed of 12 feet (3.66 M) per minute. The surface temperature rise is significant, for the board receives approximately 200 watt-seconds of energy per square inch of area. Typically, surface temperatures in excess of 300 degrees F* are experienced. The aforementioned 200 watt-seconds per square inch (6.45 cm$^2$) energy requirement is for photopolymer whose surface is exposed to air. However, most all of the tested photopolymers are affected by air to the extent that the exposure energy can be reduced to only 50 watt-seconds per square inch (6.45 square cm) when the air is completely excluded by the mating process described herein.

A phototool, as used herein, is a transparent sheet with radiation opaque areas corresponding to the image to be reproduced, and this phototool is placed between the UV lamp and the photopolymer surface to control those areas of photopolymer to be hardened. The terms photoimage, photomask and phototool can be used interchangeably.

\* (= 149°C)

While the prior art images the coated PWB with the phototool off-contact, it is not cost-effective, since an expensive collimated light source is required; other light sources will produce light undercutting, reduced line widths, and loss of line fidelity. In order to use a non-collimated light source and still achieve fine line imaging, it is necessary for the phototool image bearing surface to be adjacent the photopolymer layer surface, as is accomplished herein.

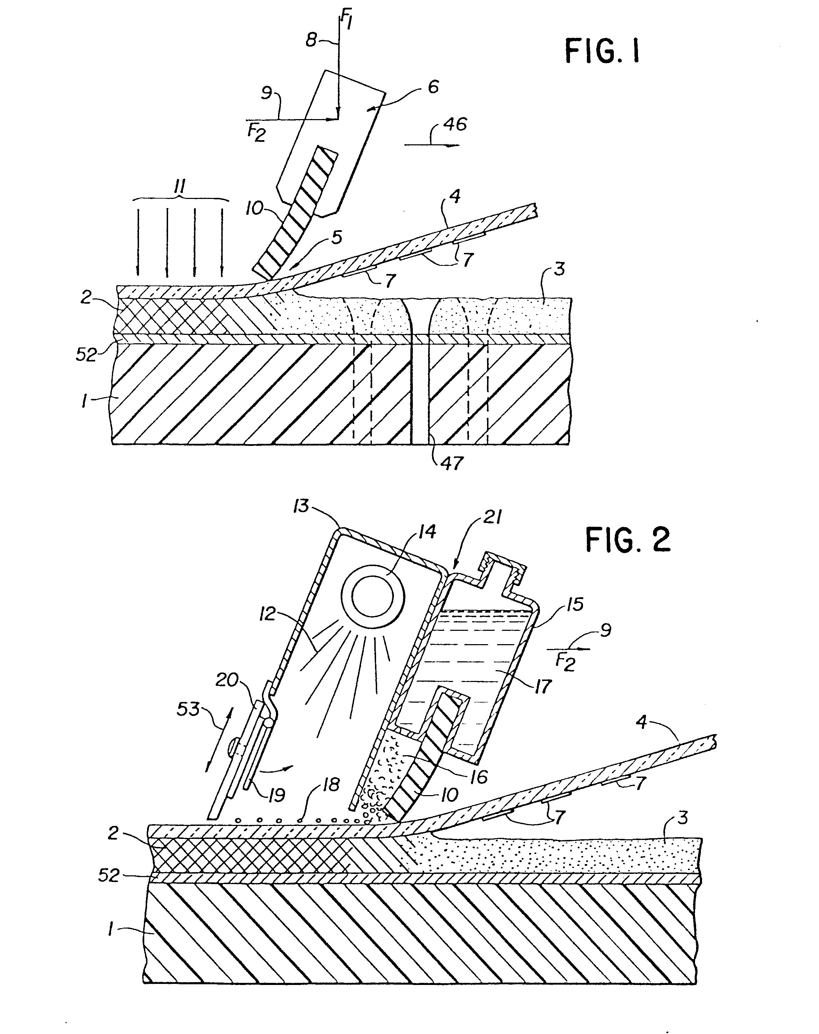

Figure 1 shows a section of PWB substrate 1 and the prototool 4 being mated to the photoploymer layer surface 3. PWB 1 has been previously roughly coated with the photopolymer layer 3. Phototool 4 is positioned above and off contact with PWB 1 and its conductor layer 52 with opaque areas 7 registered to drilled holes 47 in the PWB 1. Assembly 6 movable in the direction of arrow 46 has rubber blade 10 of 50 durometer, which traverses the top surface of phototool 4. Force $F_1$ in direction 8 on phototool 4 causes the phototool to contact the photopolymer and force $F_2$ in the direction of movement 9 causes blade 10 to traverse the topside of the phototool and progressively mate the phototool with the photopolymer. This technique purges the photopolymer of air bubbles which may have been entrapped during the coating cycle, and also saves energy and reduces processing time by removing air contact with the photopolymer surface 3.

This mating technique has several highly desirable features not readily obtainable otherwise. First, the photopolymer surface, when coated, may be mottled or have an orange-peel effect. These surface irregularities are smoothed out and the mated surface conforms to the smooth plastic surface topology of phototool 4 as well as the substrate such as PWB 1. In the case of a PWB the substrate carried a copper layer 52 surface which is to be conformed to the image of the phototool 4, for example. The exposed photopolymer is illustrated in Figure 1 with crosshatched photopolymer area 2 being in surface to surface contact because of the previous scanning of surface contact member 10, preferably a rubber blade, across the phototool 4 surface.

On those areas of the phototool 4 now mated with the (crosshatched) photopolymer 3, a strong holding force is maintained between the phototool and PWB surface. Thus, atmospheric pressure 11 (Figure 1) maintains the phototool in intimate contact with the photopolymer surface indefinitely, without an outside vacuum source. Phototool opaque areas 7 (which preferably do not constitute surface irregularities) are in intimate contact with the photopolymer surface 3, and the photopolymer can be exposed with a non-collimated light source 14, etc., and produce high resolution reproduction of images on the phototool in the PWB photopolymer 3 to serve as a plating resist layer.

Figure 2 shows a preferred method for curing photopolymer 3. For this purpose, UV lamp 14 and reflector-focuser 13 are mounted on the same movable transversing assembly 21 as blade 10. After the blade causes the phototool to mate with the photopolymer, light rays 12 expose and polymerize the photopolymer layer 2 directly beneath the phototool transparent areas. Light rays 12 cannot expose those areas ahead of blade 10.

Figure 2 shows the liquid coolant dispensing apparatus; reservoir 15, supplying coolant 17 to sponge 16 and thence to phototool 4 in a film shown as droplets 18 in thermal contact with the phototool 4 and photopolymer 3. Shuttering is accomplished automatically by pivoted shutter 19 as the assembly 21 is lowered into contact with phototool 4. Light shroud 20 contacts phototool 4 and slides upward along the reflector-focuser 13, and actuates the pivoting shutter 19 which opens to expose the mated photopolymer. Arrow 53 shows the reciprocal movement of the transversing assembly to move from rest into engagement on transversal and then back into a spaced separation position from the photopolymer layer 3.

Figure 2 shows 3 distinct zones or conditions of photopolymer. Photopolymer 2 under lamp 14 is polymerized as shown by crosshatching, while photopolymer 2 under sponge 16 is under vacuum but not yet exposed as indicated by lining; photopolymer 3 is not yet contacted by phototool 4 and is therefore at atmospheric pressure in contact with air as indicated by dotting. This progressive exposure method is an advancement in the art of producing printed plates with photopolymers, since present systems require a time of several seconds for drawdown of the entire phototool before the exposure.

The preferred liquid photopolymer is product number 1075 UV curable photopolymer manufactured by the M&T Chemical Company of Rahway, New Jersey. This is a negative acting polymer hardening in light struck areas and remaining liquid in opaque image marked unexposed areas. The unexposed liquid photopolymer is washed out in 50% solution of isopropyl alchohol and tri-clorethane.

These photoresists have been developed to be screen printed to a thickness of 1 to 2 thousandths of an inch (.025 mm to .05 mm), and cured by a two-lamp assembly, each lamp rated at 200 watts per linear inch (2.54 cm), with a conveyor speed of 12 feet per minute. With the disclosed equipment the phototool is placed between the lamp and PWB, subjecting the phototool to temperature ranging up to 300 degrees F.* The phototool** temperature can be reduced to less than 100 degrees F by utilizing a different lamp source and increasing the exposure time to the order of 40 seconds. One embodiment uses a polyester

* (= 149°C)    ** (= 149°C)

0141868

-17-

sheet with a high temperature silicone rubber release layer over the opaque areas 7 as the phototool sheet 4. This prevents the phototool from adhering to the cured and hardened image to damage the image bearing surface in direct contact with the liquid photopolymer layer during exposure such as to prevent reuse over many cycles. The silicone rubber layer is very thin and therefore does not seriously limit resolution available.

A technique for ₓsubstrate cooling is to force cold air, at 30 degrees F onto the substrate while under the UV lamp. This cooling technique is expensive and wasteful of energy.

A water spray on printed substrates to prevent overheating presents the hazard of water impinging on the hot lamp surface and causing catastrophic damage.

This disclosure teaches ways of introducing a liquid coolant into thermal contact with the heated phototool surface and the photopolymer layer. This is done in Figure 2 at the trailing edge of the mating blade 10. A 50 percent water-alcohol solution is applied across the width of the phototool by a sponge. While many liquids can be used, it is necessary that the phototool be wetted completely and beading of coolant prevented. The coolant absorbs heat from the phototool by evaporation, yet does not significantly reduce the transmittance of the UV light energy. The alcohol-water solution will keep the phototool temperature to 200 degrees F or lower.

As shown in Figure 2, reservoir 15 contains the coolant solution, which is applied to phototool 4 by sponge 16. When two successive lamps are used, coolant film shown as droplets 18 is partially evaporated by the first lamp 14, and remain in diminished quantity to provide phototool cooling when passing under the second UV lamp.

*(= -1°C)

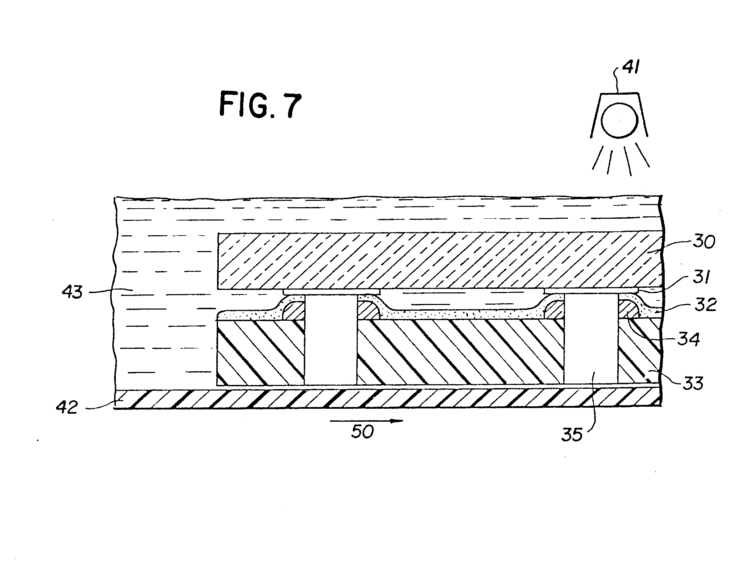

In the embodiment of Figure 7, the entire PWB 33 and overcoated photopolymer layer 32 are disposed under a coolant liquid 43 that does not change the solubility of the photopolymer, such as water.

Thus, coated printed wiring board 33 is placed in a tray 42 containing an aqueous solution 43 having a depth of approximately 1 inch.* By placing the circuit board 33 in the water all air is thereby immediately purged from the photopolymer layer 32 surface, and also purged from small irregularities in the photopolymer coating, through-holes, and slots. The glass plate phototool 30 is placed in the water and positioned over the PWB in register and lowered onto the PWB surface. At this point, the emulsion 31 of the phototool 30 is in intimate contact with the wet photopolymer 32 on the circuit board 33 traces, while the glass surface elsewhere may be separated by approximately .004 inch (.01 cm) from the photopolymer covering the base laminate. Base laminate 33 has metal conductors 34 and circuit holes 35. Photopolymer layer 32 uniformly coats the top surface of base laminate 33 and metal conductors 34. Phototool 30 with opaque emulsion areas 31 rests on the PWB so that the emulsion 31 of phototool 30 is in contact with photopolymer layer 32. Water 43 fills the volume between the photopolymer surface and the lower edge of phototool 10 so that all air is displaced.

The tubular mercury-vapor lamp and focuser-reflector array 41 directs UV light onto photopolymer 32 through aqueous layer above the phototool and below the phototool. Tray 42 is relatively moved in direction 50 to convey all areas of photopolymer 32

* (= 2,54 cm)

0141868

-19-

After exposure the phototool 30 and PWB 33 are removed from the tray and separated. All photopolyer, both hardened and unexposed, remains on the PWB 33, and none adheres to the phototool 30.

The solder mask coating is completed by spraying a solvent on the PWB 33 to wash out unhardened photopolymer. A suitable solvent is a mixture of 85 parts by volume of trichloroethane and 15 parts by volume of isopropyl alcohol. A suitable equipment for spray developing the unhardened photopolymer is the DU PONT "A" PROCESSOR, using a cycle time of the order of 20 seconds.

Thus, far, the process prepares a solder mask layer by leaving cured and hardened photopolymer from layer 32 on the surface of PWB 33. Primary imaging refers to the photopatterning of a resist, either a plating resist or an etch resist to form the basic conductor patterns on the base laminate. The disclosed process is similarly advantageous for primary imaging. The equipment and processes are the same as detailed hereinbefore for solder making, with the exception of the photopolymer. The "TYPE CNF 1110" manufactured by M & T CHEMICAL, INC. of RAHWAY, N.J. is the preferred photoresist for use as both plating and etch resist in primary imaging.

The composition of aqueous solution 43 can be varied in accordance with the specific photoresist used and the desired results. As previously described, it is important that all photoresist remains on the printed wiring substrate and that the phototransparency remain free of either hardened or liquid photoresist. With the type "311 LV" solder mask photopolymer, the addition of a liquid detergent to the aqueous solution will prevent offsetting, and the phototransparency will remain free of photoresist. The mixture ratio is of the order of one ounce of detergent per gallon of water.

The photospeed of the photoresist is improved beyond that obtained by simply displacing oxygen from the photopolymer surface. Furthermore, the addition of a small quantity of acetic acid to the aqueous solution has been observed to increase the photospeed beyond the increase achieved by water alone.

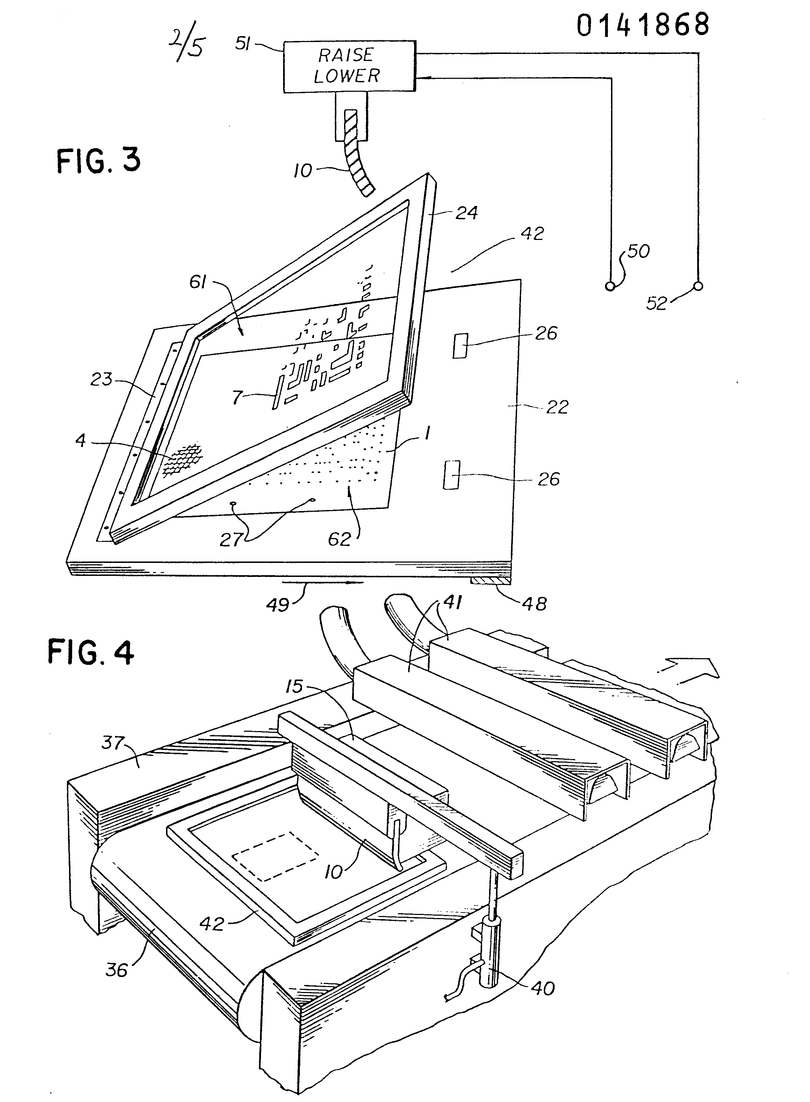

An article such as PWB 33 with an uppermost photopolymer layer 32 placed in fixture 42 can be placed on conveyor belt 36 of the exposing unit 37 in Figure 4 having UV lamps 41 with conveyor belt 36 for moving substrates under the lamps. Clearly this invention has simplified such exposing instrumentation since only container 42 with water therein is needed to dispose the photopolymer under a liquid solution during exposure in accordance with the process taught by this invention.

The use of a conveying type UV-curing unit 37 as an exposure source has two advantages. First, it permits a much higher rate of production, for many different types of images can be exposed sequentially with no UV curing unit changes. This allows a large production facility to coat the PWB with photopolymer put into a tray 42, mate the phototool when used, and to expose with a single high speed curing unit.

The second attribute of the use of UV curing unit is that substrates of exceptional length can be mated and exposed, obviating the need for oversize cabinetry.

To make a phototool, a sheet of clear polyester and a thin sheet of aluminum foil are laminated together, with a thin layer of clear silicone rubber adhesive bonding the two securely. The foil is given a pre-etch in sodium hydroxide in order to reduce the foil thickness to the order of .0001 inch (.0025 mm). The foil is then coated with a photographic etch resist, exposed, washed out and then etched again to produce the phototool image in etched foil.

Etched aluminum foil is preferred over other black emulsion systems since a large area of black emulsion would absorb large quantities of heat which could distort the phototool, while the aluminum surface reflects heat and reduces the total amount absorbed.

For use in this invention the phototool with bonded foil is stretched in phototool frame 24, Figure 3, coated and inserted into the apparatus of Figure 4. Exact registration between the phototool pattern and substrates to be imaged in production is achieved by placing a production substrate onto the substrate mounting plate 22 in register such as by use of registration pins 27. Next the master artwork is placed in frame 24 over the substrate in exact register. The mounting plate is secured to the phototool frame as in Figure 3 in register by means of hinge 23. The resilient blade 10 is drawn across the polyester sheet 4 which was previously developed from an artwork master and photopolymer coated polyester sheet, thereby transferring the artwork in the form of a foil surface 7.

The flexible polyester sheet phototool 4 is coated over the foil surface with silicone rubber adhesive, Dow Corning product code 734 RTV, which serves two major functions. First, the resilient rubber can accommodate

small dirt particles on the PWB surface. During the mating cycle PWB surface irregularities can cause a separation to exist between phototool and PWB surface which will mar the image over a much wider area then the irregularity itself. The silicone rubber, being resilient, conforms to the irregularity and reduces the marred area. Secondly, the silicone rubber adhesive forms a non-stick surface on the phototool to which hardened photopolymer will not adhere.

Thus far in this disclosure, the use of a flexible phototool has been described. The phototool need not be flexible in all cases. For example, when imaging flexible printed wiring circuits, the phototool may be a glass plate and the flexible substrate mated with the phototool by drawing the blade across the flexible substrate. Thus, in the frame of Figure 3, simply the substrate and phototool are interchanged in position. The photo scanning need then occur on the opposite side.

Figure 3 shows a fixture for mounting the phototool and PWB in register and off contact, for use when precise registration is required, when a conveyorized UV curing unit is used as the exposure source, or when a pre-registered fixture is needed.

In the fixture 42, PWB 1 mounts on base 22 and is registered via pins 27. Phototool 4 is mounted on frame 24 which maintains the phototool in registration with drilled PWB 1. Hinge 23 allows frame 24 to be raised and lowered for placement and removal of PWB 1. Spacers 26 maintain off-contact distance between phototool 4 and PWB 1 top surface.

In Figure 3, mounting base 22 has a metal strip 48 affixed to the underside, whose purpose is to cause the generation of an electrical signal when the exposure assembly is conveyed in direction 49 past a sensor 50 serving to actuate a lowering mechanism at control center 51 for positioning the mating blade 10. A similar electrical signal at 52 will in turn cause the mating blade to rise. Thus contact of the phototool at the leading edge of the image area with the blade 10 is automated. Also the signal at sensor 52 will also cause the blade to be raised automatically at the trailing edge of the image area.

The following chart shows the process steps of this invention to be followed where hole tenting is not required.

    a.   prepare phototool and install in the fixture.

    b.   coat the drilled PWB or the phototool with paste photopolymer.

    c.   install PWB in registration on the fixture.

    d.   mate the phototool with the PWB to form a sandwich.

    e.   expose the PWB to UV light through the phototool.

    f.   separate the phototool from the PWB leaving hardened photopolymer on PWB.

    g.   wash out unexposed paste photopolymer on PWB and post cure if desirable.

    h.   blot the phototool to remove any photopolymer paste adhering thereto, and reinstituting the cycle.

The PWB is coated, Step b, by screen printing to the desired thickness, normally from 0.5 to 2 thousandths of an inch (.013 mm to .051 mm), as determined by plating bath requirements (temperature, immersion time, plating current density and chemical composition), and the plating thickness to be deposited. The photopolymer thickness is controlled primarily by the screen fabric thickness and percent open area. For example, a 156 mesh polyester fabric will coat the PWB to a thickness of approximately 1 mil, while a 230 mesh fabric will deposit a coating .3 mils (.076 mm) thick. The phototool is maintained off-contact, but correctly positioned above the coated PWB by the fixturing as shown in Figure 3. Off contact distance is of the order of .060 inches (.15 cm) for a 12 by 18 inch (.3 by .46 M) PWB. The phototool is mated with the coated PWB by pressing the blade down at one end of the PWB and drawing the blade across the PWB length, using a downward force of 2 pounds (0.9 Kg) per linear inch (2.54 cm) of blade length.

The washout of unexposed photopolymer, Step f, is accomplished by using a solvent spray bath, for example trichlorethane, lasting from 10 to 30 seconds.

Step h, the blotting of the underside of the phototool is required to smooth out unexposed photopolymer which remains on the phototool after the exposed PWB is removed. If left on the phototool, then the next image may be marred by the presence of entrapped air. Usually it is necessary to blot the phototool after every second or third exposure cycle, depending on the photopolymer coating thickness on the PWB. Blotting is accomplished by use of a rubber roller to obliterate the patterns and distribute the remaining photopolymer more evenly.

Where selected holes are to be tented by the photoimaged resist, the primary difference in the procedures for hole tenting is Step b, in which the phototool is coated rather than the PWB.

Another difference is that blotting the phototool is not necessary when tenting, since the step b. step, phototool coating, obliterates the residual photopolymer patterns.

As described earlier, the phototool has a thin layer of clear silicone rubber on the underside. When a coating of photopolymer is applied by screen printing (or other means) onto the silicone rubber, the photopolymer will develop "fish-eyes" or voids which will continue to expand in area with time. This is caused by the inability of the wet photopolymer to grip the silicone rubber, and the photopolymer surface tension causes the photopolymer to form beads, similar to the beading of water on a waxed surface.

In order to prevent the formation of fish-eyes or voids, the disclosed apparatus exposes or flashes the photopolymer through the phototool as the coating is being applied. This flashing step is of sufficient intensity to slightly polymerize the photopolymer over the clear areas of the phototool, but not to the point of exterior surface hardening. That photopolymer above the phototool opaque areas need not be flashed.

It would appear that this flashing step is critical with regard to lamp intensity and exposure time, but in practice it is not. The photopolymer listed in this disclosure, and all photopolymers tested are air-inhibited, meaning that the photopolymer cure with less UV energy in the absence of air than is required in the presence of air. Thus, as the phototool is coated with photopolymer via screen printing, only a thin line of photopolymer immediately under the squeegee is deprived of air, for the screen fabric is off-contact, and touches the phototool only along a line underneath the squeegee. Previously deposited photopolymer, though exposed, will retain a wet surface for good adhesion to the substrate to be printed.

This flashing technique is an important aspect of tenting holes in PWB resist imaging, for the flashing ensures a thicker film over the tented hole than would be attained without flashing, for without flashing the photopolymer would thin out at the edges of the holes and would be more likely to break down during washout and immersion in the plating solution.

This flashing step has produced a polymerized image which is hardened on the phototool side, but wet on the exterior side, so that the next step of phototool mating with the substrate can be considered to be an image transfer technique.

UV curing units can be used for producing images per this disclosure by the addition of a mating blade assembly and phototool coolant-dispensing apparatus as shown in Figure 4, where conveyor belt 36 conveys the phototool assembly 42 under blade 10. Blade 10 is pulled downward by vacuum cylinders 40, for a period of time beginning when the leading edge of metal strip on the bottomside of phototool assembly 42 bridges electrical contacts mounted under conveyor belt 36. The conveyor belt on most UV curing units are made of fiberglass mesh encased in a heat resistant plastic, enabling the filaments comprising the electrical contacts to extend thru the mesh and contact the blade control strip. This action permits precise control of the blade and prevents the blade from striking the leading or trailing edge of the phototool frame. Co-mounted with blade 10 is reservoir 15 containing the phototool coolant which is dispensed by a sponge not shown in Figure 4.

Advantages of the process afforded by this invention are numerous, and the characteristics of the materials synergistically relate to the photoimaging process by producing higher resolution at lower material cost, in shorter time, at lower energy cost, at lower temperatures and with less sensitive light sources.

For example, the U-V curable resists of the wet polymer type have been primarily used in screen printing techniques to print an image for photocuring. It is found in this invention that these resists can be exposed through phototransparencies to produce high resolution images.

The photoimaging method provides for a faster production method, since it is found that air in contact with the paste polymer surface inhibits photocuring. Thus, by covering the surface with the photoimage transparency energy density for photocuring is reduced to between 20 and 50 percent of that necessary for air exposed surfaces.

This effect is most important because of the effect of heat on phototransparencies. Also the effect on copper clad printed wiring boards is important. Reductions of energy then also make the end products much more reliable and prevents distortions that affect resolution. For example, a photocured PWB might rise in temperature from 75 to 250°F when exposed to tubular mercury vapor lamps for photoimaging. Lower energy requires less exposure time.

Further significant time is saved in development as compared with hard photopolymers, soft unexposed paste polymer can be washed out in the development stage in ten seconds. Hard polyers require a minute or more, and also resolution suffers. The ratio of hardness to softness for exposed to unexposed polymer is much higher for past polymers than the dry film polymers. This in part results in potential resolutions of line widths of .005 inches (.013 cm) in dry films as compared with .001 inches (.0025 cm) with paste polymers which give better boundaries and less undercutting.

The advantages of using non-collimated light with paste polymers permitting phototransparency direct contact are set out heretofore.

Resolution is increased with thinner layers as is development time and heat, etc. Dry film polymers are available in a few choices between .00075 to .0015 inches (.0019 to .0038 cm) whereas the paste photopolymers can be screen printed at any thickness between .0002 to .002 inches (.0005 to .005 cm).

Other processing steps required in dry film photoimaging can be completely eliminated at significant time and energy savings. Thus, dry film requires heat and pressure to laminate at 200°F.* It must then be held 15 minutes before exposure to stabilize. Again exposure heats the film and it must be cooled and held at ambient temperature for about 15 minutes before developing. Otherwise clean developing cannot be achieved. With the paste polymers, coating, exposure and developing proceeds in less than one minute without waiting time.

Special phototools used for producing high resolution photoimages with photopolymer resins are produced by engaging the photoimage bearing surface of an image bearing photransparency directly with the surface of a liquid photopolymer. This results in special conditions and requirements not heretofore necessary, particularly when it is desired to use phototools over and over in production quantities.

Thus the surface in contact with the liquid photopolymer must be wetted to prevent beading or air

* (=93,3°C) bubbles, which is inconsistent with the requirement to prevent adherence to the hardened photopolymer images cured on the phototool-image bearing surface, the removal of all cured materials from the phototool and the lack of interference of residual liquid photopolymer on the phototool surface after stripping from the developed image. This invention therefore provides a phototool with an image bearing surface meeting these requirements by dying through a very thin plastic film of the group constituting polyethylene and polypropylene.

This process takes advantage of the film porosity to expose an image pattern through a blocking stencil on the film surface to a solution of dye and solvent that evaporates and penetrates the film pores by absorption to dye the film permanently. The stencil can then be removed to have a phototool not hurt by surface scratching or wear. The dye may be a product sold as "Atlasol" Golden Yellow by Atlantic Chemical Corp. of Nutley, N.J. in a solution with butyl cellusolve solvent.

The stencil may be photo formed on a thin film of liquid photopolymer on the contact surface of the film imaged by a phototransparency through the thin polypropylene, etc. film layer overlaminating the phototransparency image bearing surface and held in place by a thin pressure sensitive adhesive layer. Since the dye patterns extend through the film and are substantially identical to those patterns on the phototransparency, no undercutting will occur during exposure and there is a scratch proofed finish because the dye extends through the film thickness. Non-collimated light thus may be used for exposure without resolution loss.

This layer as is the case with the aforesaid aluminum image, does not heat as does silver halide dark surface, but is opaque to the UV curing radiation. Polyolefin film and particularly polypropylene film because it is clear, porous and has the desired sticking properties is a preferred release coating rather than the aforesaid silicone coatings.

Use of this release type film as an intervening layer without carrying the image cuts down resolution significantly, and needs be used only with collimated light, which is expensive.

An alternate method for achieving the dyed pattern is to combine into a single liquid the preferred "1075" photopolymer, the butyl cellosolve and the dye. This composite is sprayed over the surface of the polypropylene film and selectively exposed through the phototransparency and through the polypropylene film. Light struck photopolymer is hardened, immobilizing the dye particles. Non-light struck photopolymer remains in the liquid state and while the solvent is being evaporated dye particles are absorbed into the pores of the polypropylene. An alternate porous film which can be used in the disclosed process is polyethylene. However, polyethylene does not have the clarity nor high-temperature service range as polypropylene.

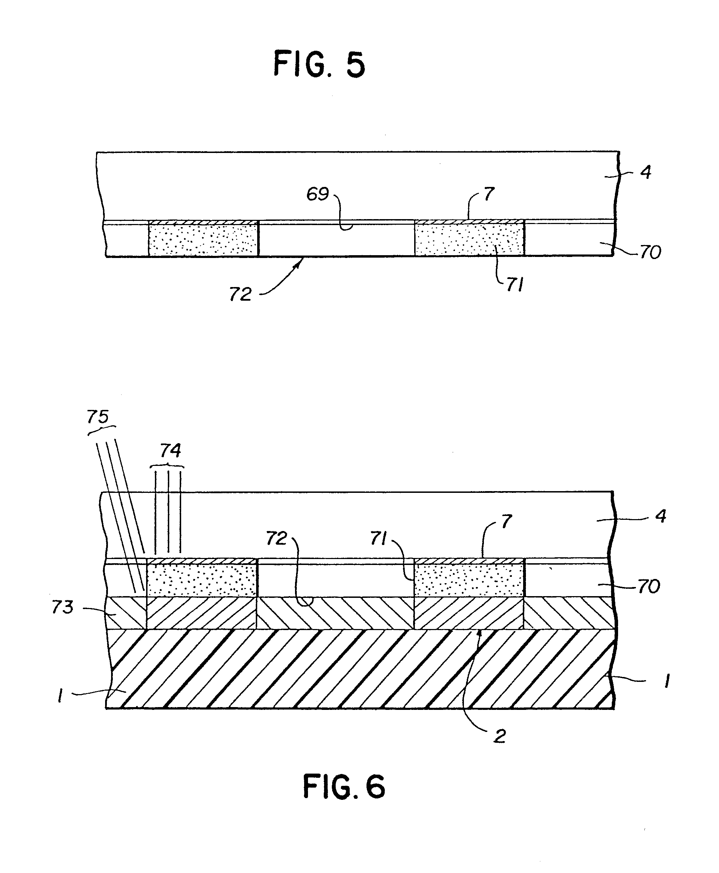

This latter advantageous phototool product and method is better understood by reference to Figures 5 and 6 of the drawing. As may be seen the phototransparency film 4 with opaque aluminum images 7 on image bearing surface 69 have over-laminated thereon the thin polypropylene film sheet layer 70, wherein the sections 71 are dyed in the manner aforesaid to extend through the entire thickness of film layer 70.

In Figure 6 the surface 72 is wetted by liquid photopolymer of layer 73 into which the surface 72 is merged as before described in an air free surface contact. Furthermore, surface 72 does not adhere to exposed, cured and hardened thereon photo cured polymer sections 2 of the photopolymer film layer 73 on substrate 1. Thus, the phototool comprising layers 4 and 70 may be stripped for developing the photoimage on substrate 1 by washing out the liquid uncured parts of the layer 73 in a solvent to provide a photoimaged product, such as a printed wiring board pattern or solder mask thereover, etc., of highest resolution. The stripped phototool is then preferably blotted to smooth out any of the unexposed liquid photopolymer of layer 73 that sticks thereon. This is not necessary in the event the liquid photopolymer layer is positioned on the flexible phototool layer surface 72 by silk screening or the like in a very thin layer of known thickness.

Note in particular very good resolution is retained without collimated light because of the dyed through sections 71 in the polypropylene (etc.) film layer 70 which block rays 75 not collimated as rays 74 are, which would be necessary to save the high resolution if release film layer 70 were interposed without the photoimage dyed through feature of this invention.

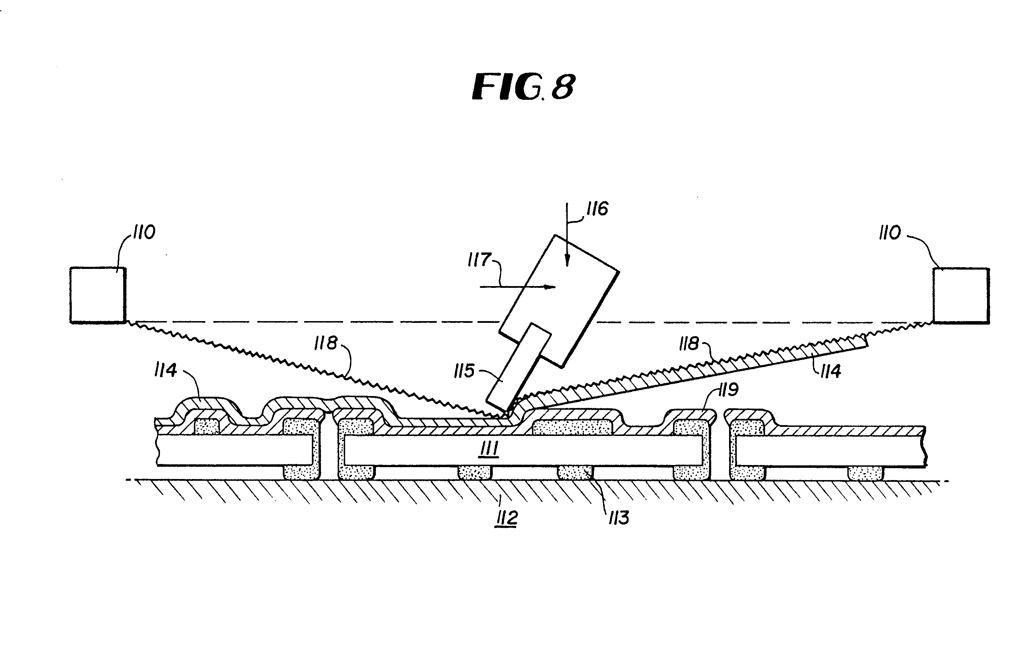

As shown in Figure 8, a printed wiring board 111 having metal conductors 113 thereon and metal covered holes therethrough rests on surface 112. Screen holding members 110 hold screen 118 tautly closely over and parallel to the board 111 so that the blade 115 can scan the screen 118 by means of forces 116, 117 and laminate the layer 114 of photopolymer thereon onto a first layer 119 of photopolymer disposed directly on the surface of board 111. The photopolymer layer 114 on the screen may be either a dry film positive acting photopolymer held adhesively on screen 118 or a liquid film negative acting photopolymer partially cured on the screen before transfer by flashing in air with a UV light source. After lamination the printed wiring board polymer layers are exposed to the UV light source through a photoimage tool.

When a positive acting dry film upper layer is used, the unhardened photopolymer layer 114 is washed out in a trichloroethane spray, as is any liquid photopolymer layer 119 not covered by hardened portions of layer 114. This film also generally is covered by a polyethylene protective sheet or the like and the outer laminated on layer serves to exclude air from the surface of the inner layer.

The outer layer 114 thickness is about .0025 cm, and when partially cured liquid photopolymer does not tend to starve or thin out over the conductors 113 on the printed wiring board. Final curing through a suitable phototool in registration with the wiring pattern leaves a solder mask coating on the board with unhardened photopolymer over the desired circuit conductor pads, which is removed by solvent.

This embodiment characterized by lamination of two layers of photopolymer provides the advantages of using less photopolymer and less expensive photopolymers, attaining thicker uniform layers over irregular surfaces preventing fisheyes or residual unremoved polymer over through holes, and achieves high resolution. In essence this invention produces a high resolution result similar to that using a much more expensive thick dry photopolymer film which in turn requires much longer processing time and much greater energy. Also the holes through the board are clean, whereas with dry film and poor exposure this is not feasible. Also better adhesion to conductors results and wrap around wrinkles and irregular surfaces are eliminated.

As before discussed, advantages in tenting out holes on a printed wiring board occur by transferring the photopolymer from a screen 118 onto the board 111. If a liquid photopolymer layer 114 is used, it may be flash irradiated in air for partial polymerization to improve the tenting characteristics.

Having therefore set out the construction and operation of the invention and having advanced the state of the art, those features of novelty believed descriptive of the spirit and nature of the invention are set forth with particularity in the appended claims.

Claims

1. The process of radiating the surface of a negative acting liquid photopolymer layer soluble in a solvent before curing which thereafter produces a change of photopolymer solubility characterized in excluding gas and air from the surface of the photopolymer to be radiated during the radiation thereof to reduce the amount of radiation required to cure the photopolymer by means of contacting the photopolymer surface with a removable transparent non-gaseous body that does not change the photopolymer solubility during radiation, and curing the photopolymer layer through a transparent phototool sheet having a photoimage pattern on a receiving surface thereof adjacent the photopolymer to thereby comprise said body thereby to produce high resolution image reproduction in the photopolymer layer.

2. The process of Claim 1 further characterized in forming the photoimage pattern by dying the photoimage pattern into the body of said transparent sheet.

3. The process of Claim 1 further characterized by laminating the phototool sheet to the photopolymer surface by traversing the nonimage bearing surface of said phototool sheet disposed adjacent to but separated from the photopolymer layer surface with a resilient scanning member drawn across the photopolymer layer to exclude gas and air as the contact is made with the photopolymer layer by the phototool sheet.

4. The process of Claim 3 further characterized by scanning the phototool sheet concurrently with the traversing of the scanning member with a radiation source directing radiation through the image bearing surface portion contacting said photopolymer layer thereby to progressively cure said photopolymer layer while scanning.

5. The process of Claim 1 further characterized by dissipating heat during the cure by disposing a liquid in thermal contact with said photopolymer layer.

6 . The process of Claim 1 further characterized by forming a sandwich of a photopolymer layer between two sheets a first of which is transparent and bears a photoimage pattern on its internal surface adjacent the photopolymer layer.

7 . The process of Claim 1 further characterized by forming a film pack sandwich by disposing the photo-layer between two sheets.

8 . Apparatus for radiating the surface of a liquid photopolymer layer to cure at least a portion thereby by producing a change of photopolymer solubility characterized in

a removable transparent non-gaseous body that does not change the photopolymer solubility contacting the surface of the photopolymer layer to be radiated, and

a phototool sheet transparency with a photo image pattern on one surface thereof adjacent the photopolymer surface to be radiated, thereby providing a high resolution image reproduction in the photopolymer layer.

9 . Apparatus as defined in Claim 8 further characterized by an uncollimated radiation source disposed to expose said photopolymer layer through said photo image pattern.

10. Apparatus as defined in Claim 8 further characterized by said photo image pattern on one surface of said phototool sheet transparency comprising a photo image pattern dyed into the body of said transparent sheet.

11. A photopolymer film pack assembly characterized by a photopolymer layer sandwiched between two sheets, a first of which is transparent with a photo image bearing inner surface adjacent the photopolymer layer.

12. A film pack assembly as defined in Claim 11
further characterized by a negative acting  photopolymer
layer soluble in a solvent before curing in the presence
of radiation passed through said transparent sheet.

13. The process characterized by laminating a first
layer of liquid negative acting photopolymer onto the
irregular surface of a printed wiring board and thereafter
laminating thereover a second layer of photopolymer.

FIG. 1

FIG. 2

2/5

0141868

FIG. 3

RAISE LOWER

FIG. 4

## FIG. 5

## FIG. 6

# FIG. 7

# FIG.8

**European Patent Office**

**EUROPEAN SEARCH REPORT**

## DOCUMENTS CONSIDERED TO BE RELEVANT

| Category | Citation of document with indication, where appropriate, of relevant passages | Relevant to claim | CLASSIFICATION OF THE APPLICATION (Int. Cl. ³) |
|---|---|---|---|
| X,Y | PATENTS ABSTRACTS OF JAPAN, vol. 5, no. 122 (P-74)[794], 7th August 1981; & JP - A - 56 64 344 (ASAHI KASEI KOGYO K.K.) 01-06-1981 * Abstract * | 1-13 | G 03 F 7/16 G 03 F 7/20 |
| | --- | | |
| X,Y | PATENTS ABSTRACTS OF JAPAN, vol. 5, no. 122 (P-74)[794], 7th August 1981; & JP - A - 56 64 343 (ASAHI KASEI KOGYO K.K.) 01-06-1981 * Abstract * | 1-13 | |
| | --- | | |
| X | GB-A-2 043 274 (N.V. APR. EUROPE) * Whole document * | 1 | |
| | --- | | **TECHNICAL FIELDS SEARCHED (Int. Cl. ³)** |
| Y,D | US-A-3 837 887 (KIYOSKI AKA MATSU) * Whole document and figure 6 * | 1-13 | G 03 F 7/16 G 03 F 7/20 |
| | --- | | |
| Y | FR-A-2 407 496 (TIBBETTES) * Figure 4; example 12 * | 1-13 | |
| | --- | | |
| Y | DE-A-3 049 482 (K. PAIERL) * Whole document * | 5 | |
| | --- | | |
| A | GB-A-1 472 978 (GRACE) * Whole document * | 1 | |
| | ---    -/- | | |

The present search report has been drawn up for all claims

| Place of search THE HAGUE | Date of completion of the search 17-07-1984 | Examiner RASSCHAERT A. |
|---|---|---|

| | **DOCUMENTS CONSIDERED TO BE RELEVANT** | | Page 2 |
|---|---|---|---|
| Category | Citation of document with indication, where appropriate, of relevant passages | Relevant to claim | CLASSIFICATION OF THE APPLICATION (Int. Cl. ³) |
| A | US-A-4 056 423 (N.E. HUGHES) <br> * Whole document * <br><br> --- | 1 | |
| A | US-A-3 971 691 (M.J. CAIRNS) <br> * Whole document * <br><br> --- | 1 | |
| E | EP-A-0 096 863 (E.I. DU PONT) <br> * Whole document * <br><br> ----- | 1-13 | |
| | | | **TECHNICAL FIELDS SEARCHED (Int. Cl. ³)** |

The present search report has been drawn up for all claims

| Place of search <br> THE HAGUE | Date of completion of the search <br> 17-07-1984 | Examiner <br> RASSCHAERT A. |
|---|---|---|